# EUROPÄISCHE PATENTSCHRIFT

(11) **EP 0 345 443 B1**
(45) Veröffentlichungstag und Bekanntmachung des Hinweises auf die Patenterteilung: **25.10.1995**
(21) Anmeldenummer: 89106877.7
(22) Anmeldetag: 17.04.1989
(51) Int. Cl.: H01L 21/268

(54) **Verfahren zum Kurzzeittempern einer Halbleiterscheibe durch Bestrahlung**
Process for the rapid thermal annealing of a semiconductor wafer using irradiation
Procédé de traitement thermique rapide d'une plaquette semi-conductrice par irradiation

(30) Priorität: 09.05.1988 DE 3815836
(43) Veröffentlichungstag der Anmeldung: 13.12.1989
(73) Patentinhaber: SIEMENS AKTIENGESELLSCHAFT, 80333 München (DE)
(72) Erfinder: Kakoschke, Ronald, Dr., D-8000 München 71 (DE)

(56) Entgegenhaltungen:
- DE-A- 3 139 711
- DE-A- 3 139 712
- US-A- 4 469 529
- US-A- 4 493 977
- PATENT ABSTRACTS OF JAPAN, Band 9, Nr. 150 (E-324)(1873), 25. Juni 1985 ; & JP-A-60 32 317
- PATENT ABSTRACTS OF JAPAN, Band 11, Nr. 190 (E-517)(2637), 18. Juni 1987 ; & JP-A-62 20 308
- PATENT ABSTRACTS OF JAPAN, Band 11, Nr. 31 (E-475)(2478), 29. Januar 1987 ; & JP-A-61 198 735
- JOURNAL OF VACUUM SCIENCE & TECHNOLOGY A, Band 4, Nr. 3, Teil 1, Mai-Juni 1986, Seiten 1005-1008, American Vacuum Society, Woodbury, N.Y., US ; J. NULMAN et al.: "Ultrathin gate dielectrics thermal processing"
- PATENT ABSTRACTS OF JAPAN, Band 10, Nr. 13 (E-399), 26. April 1986 ; & JP-A-60 247 934
- ELECTRONICS LETTERS, Band 21, Nr. 16, 1. August 1985, Stevenage, Herts., GB ; Y. HIROSA et al.: "Improvement of InP MISFET characteristics using infra-red lamp annealing"
- PATENT ABSTRACTS OF JAPAN, Band 9, Nr. 234 (E-344)(1957), 20. September 1985 ; & JP-A-60 88 431
- PATENT ABSTRACTS OF JAPAN, Band 7, Nr. 58 (E-163)(1203), 10. März 1983 ; & JP-A-57 207 345
- APPLIED PHYSICS LETTERS A. Solids and Surfaces, Band A33, Nr. 1, Januar 1984, Springer Verlag, Heidelberg, DE ; A.N. LARSEN et al.: "Behaviour of implanted arsenic in silicon single crystals subjected to transient heating with incoherent light"

## Beschreibung

Die Erfindung betrifft ein Verfahren zum Kurzzeittempern einer Halbleiterscheibe durch elektromagnetische Bestrahlung mit einer Hauptbestrahlungsanordnung, die mindestens eine Bestrahlungsquelle aufweist und den größten Teil der zur Erwärmung der Halbleiterscheibe benötigten Energie überträgt.

Bei der Herstellung elektronischer Bauelemente auf Halbleiterscheiben gewinnen Kurzzeittemperverfahren (Englisch: Rapid Thermal Processing = RTP) immer mehr an Bedeutung. Dabei werden die Halbleiterscheiben einzeln in eine Prozeßkammer gebracht und dann in definierter Atmosphäre sehr schnell und möglichst gleichmäßig aufgeheizt, z. B. durch Bestrahlung aus einer intensiven Lichtquelle. Dabei wird im allgemeinen die Temperatur mittels eines Pyrometers an einem Meßpunkt in der Scheibenmitte gemessen. Das Pyrometersignal regelt dabei die Leistung der Lampen und damit die Lichtintensität derart, daß ein vorgegebener Temperatur-Zeit-Zyklus möglichst exakt eingehalten wird. Ein typischer Temperatur-Zeit-Zyklus zum Ausheilen von Ionenimplantationen ist z.B. eine Aufheizrate von 300°C pro Sekunde auf 1100° C, eine anschließende Temperzeit von 5 Sekunden auf 1100° C und eine Abkühlrate von 100° C pro Sekunde.

Eine Voraussetzung zur Erzielung hoher Ausbeuten bei Kurzzeittemperprozessen ist eine ausreichend homogene Temperaturverteilung über der Halbleiterscheibe. Diese Anforderung stellt jedoch vor allem bei großen Halbleiterscheibendurchmessern ein noch nicht befriedigend gelöstes Problem dar.

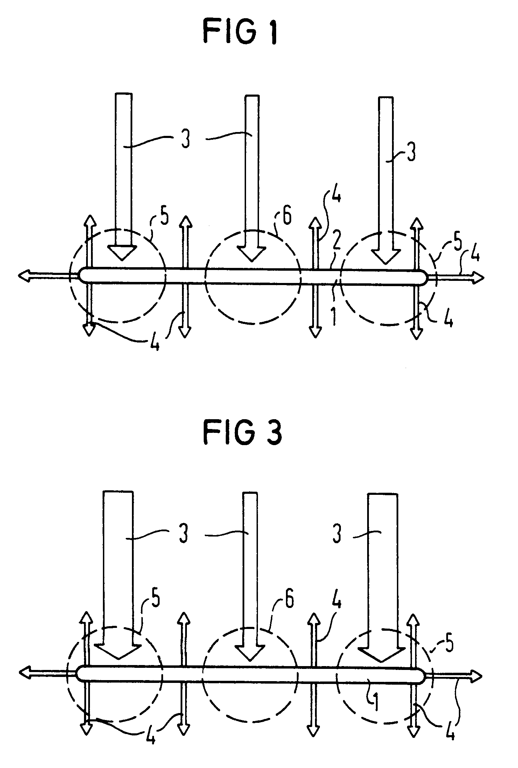

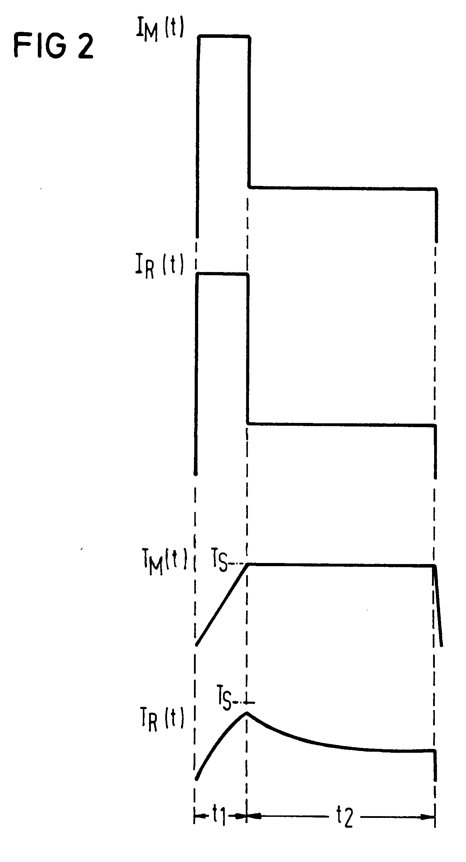

Bei der im weiteren folgenden Erläuterung der Problematik sind die FIG 1 und 2 zu betrachten.
FIG 1 zeigt eine Halbleiterscheibe 1, deren Oberseite 2 ganzflächig mit elektromagnetischer Strahlung 3 gleicher Intensität bestrahlt wird. In Folge der Wärmeabstrahlung 4, die am Halbleiterscheibenrand 5 erhöht auftritt, stellt sich am Halbleiterscheibenrand 5 eine niedrigere Temperatur als in der Halbleiterscheibenmitte 6 ein.

In FIG 2 ist der Verlauf der Strahlungsintensität I_{M} in der Halbleiterscheibenmitte 6 und der Verlauf der Strahlungsintensität I_{R} am Halbleiterscheibenrand 5, die in diesem Fall gleich sind, sowie der Verlauf der Temperatur T_{M} in der Halbleiterscheibenmitte 6 und der Temperatur T_{R} am Halbleiterscheibenrand 5 während eines Temperprozesses mit einer Aufheizphase t₁ und einer Temperphase t₂ gezeigt. Aus den Kurven ist ersichtlich, daß eine homogene Intensitätsverteilung der Bestrahlung über der Halbleiterscheibe zu einer inhomogenen Temperaturverteilung führt, da wegen der zusätzlichen Fläche am Halbleiterscheibenrand 5 die Wärmeabstrahlung dort erhöht ist.

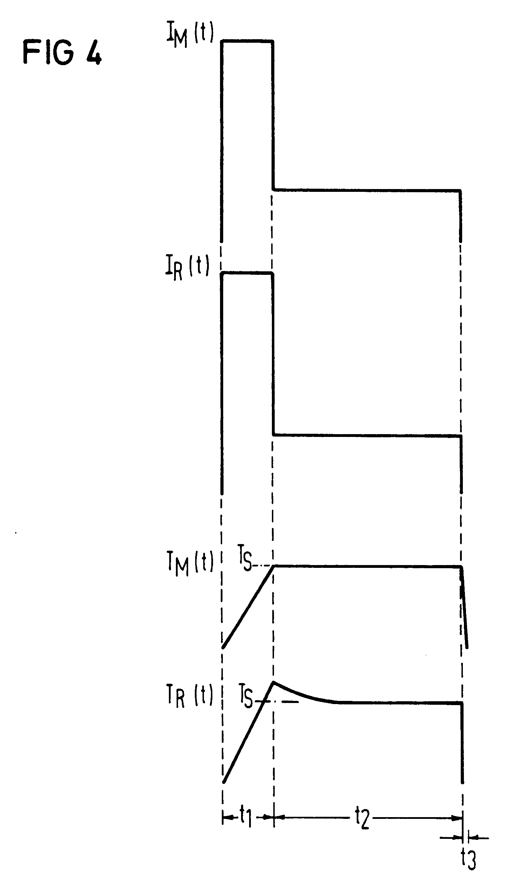

Im weiteren wird der Stand der Technik anhand der FIG 3 und 4 erläutert.

FIG 3 zeigt eine Halbleiterscheibe 1, deren Randbereich 5 im Vergleich zur Halbleiterscheibenmitte 6 mit erhöhter Intensität bestrahlt wird. Die Intensitätsverteilung der Bestrahlung ist dabei schematisch durch unterschiedlich breite Pfeile angedeutet. Auf diesem Prinzip beruhende Verfahren werden zur Verbesserung der Temperaturverteilung bei den bekannten RTP-Anlagen, z.B. der Firma Varian GmbH, D-7000 Stuttgart-Vaihingen, Prospekt-Nr. VAC 6057 und der Firma Peak Systems, ING. Fremont, USA, ALP 6000, Mai 1986 angewendet. Dabei ist das Verhältnis der Intensität I_{M} in der Halbleiterscheibenmitte 6 zur Intensität I_{R} am Halbleiterscheibenrand 5 während des gesamten Temperprozesses konstant.

FIG 4 zeigt den Verlauf der Intensität I_{M} der Bestrahlung in der Halbleiterscheibenmitte 6 und der Intensität I_{R} der Bestrahlung am Halbleiterscheibenrand 5, sowie den Verlauf der Temperatur T_{M} in der Halbleiterscheibenmitte 6 und der Temperatur T_{R} am Halb leiterscheibenrand 5 während eines Temperprozesses mit einer Aufheizphase t₁ und einer Temperphase t₂.

Die Bestrahlungsleistung wird durch Pyrometermessungen in der Halbleiterscheibenmitte 6 so geregelt, daß ein vorgegebener Temperatur-Zeit-Zyklus T_{M}(t) in der Scheibenmitte 6 eingehalten wird. Während der Aufheizphase t₁ wird mit sehr hoher Intensität I_{M}, I_{R} bestrahlt, wobei der Halbleiterscheibenrand 5 stärker bestrahlt und daher auch schneller aufgeheizt wird.

Wenn die Halbleiterscheibenmitte 6 die Solltemperatur T_{S} erreicht hat, ist die Temperatur am Halbleiterscheibenrand 5 wegen der dort größeren Aufheizgeschwindigkeit deutlich höher. Erst während der Temperphase t₂ stellt sich dann aufgrund des dafür ausgelegten konstanten Intensitätsverhältnisses I_{M}/I_{R} nach einiger Zeit eine homogene Temperaturverteilung mit dem Sollwert T_{S} ein. Während der Abkühlphase t₃ nach Abschalten der Bestrahlung kühlt dann der Halbleiterscheibenrand 5 schneller ab als die Halbleiterscheibenmitte 6.

Der Temperatur-Zeit-Verlauf T_{R}(t) am Halbleiterscheibenrand 5 unterscheidet sich also wegen dieses dynamischen Verhaltens von dem Temperatur-Zeit-Verlauf T_{M}(t) der Halbleiterscheibenmitte 6. Dabei hängt die Zeit bis zum Erreichen der homogenen Temperaturverteilung in der stationären Temperphase von der Masse der Halbleiterscheibe und dem Betrag der Solltemperatur T_{S} ab. Sie beträgt z. B. für eine Halbleiterscheibe mit einem Durchmesser von ca. 15 cm (6 Zoll) bei einer Solltemperatur T_{S} von 1100° C fünf bis zehn Sekunden. Dadurch können bei kurzen Temperzeiten, z.B. von 5 Sekunden, Gebiete am Halbleiterscheibenrand 5 im Mittel eine um bis zu 50° C höhere Temperatur als Gebiete in der Halbleiterscheibenmitte 6 erfahren. Dieser Unterschied fällt umso mehr ins Gewicht, je kürzer die Temperzeiten sind.

Der inherente Vorteil des Kurzzeittemperns, nämlich schnelle Aufheizgeschwindigkeiten und kurze Verweildauern auf hohen Temperaturen, kann wegen der die Ausbeute begrenzenden Temperaturinhomogenität nicht voll ausgeschöpft werden. Dies wirkt sich speziell auf die sich in der Produktion von elektronischen Bauelementen auf Siliziumbasis durchsetzenden großen Halbleiterscheiben (Durchmesser von ca. 15 cm (6 Zoll)) ungünstig aus.

Das Dokument Patent Abstracts of Japan, Band 9, Nr. 150, (E-324)[1873] 25. Juni 1985 & JP-A-60 32317 offenbart ein Verfahren zur Wärmebehandlung einer Halbleiterscheibe durch elektromagnetische Bestrahlung mit einer Hauptbestrahlungsanordnung gemäß dem Oberbegriff des Anspruchs 1.

Bei allen bekannten Kurzzeittemperverfahren wird der durch das dynamische Verhalten verursachten Temperaturinhomogenität nicht entgegengewirkt.

Aufgabe der Erfindung ist es daher, ein Verfahren zum Kurzzeittempern einer Halbleiterscheibe durch Bestrahlung anzugeben, das Temperprozesse mit einer während des gesamten Temperprozesses homogenen Temperaturverteilung über der Halbleiterscheibe ermöglicht.

Diese Aufgabe wird durch ein Verfahren der eingangs genannten Art dadurch gelöst, daß
a) eine Hauptbestrahlungsanordnung verwendet wird, die so beschaffen ist, daß die Halbleiterscheibe mindestens einseitig so bestrahlt wird, daß die Intensitäten der auf dem mittleren Bereich der Halbleiterscheibe und der auf den Randbereich der Halbleiterscheibe gerichteten Strahlung gleich sind und
b) daß zum Ausgleich der im Randbereich der Halbleiterscheibe erhöht auftretenden Wärmeabstrahlung zusätzlich eine die Halbleiterscheibe aufheizende elektromagnetische Strahlung auf den Randbereich gerichtet wird, deren Intensität zeitlich so verändert wird, daß während des gesamten Temperprozesses die Temperaturen im mittleren und im Randbereich der Halbleiterscheibe gleich sind,
c) daß als Hauptbestrahlungsanordnung eine Bestrahlungsquelle (103, 63) mit einem Reflektor (101, 111) über der Halbleiterscheibe (1) angeordnet wird, die so gestaltet ist, daß bei einem bestimmten Abstand der Halbleiterscheibe (1) vom Reflektor (101, 111) die Halbleiterscheibe (1) so bestrahlt wird, daß die Intensitäten (I_{M}, I_{R}) der auf dem mittleren Bereich (6) und auf den Randbereich (5) treffenden Strahlung gleich sind und daß bei einem anderen Abstand der Halbleiterscheibe (1) vom Reflektor (101, 111) die Intensität (I_{R}+I_{Z}) der auf den Randbereich (5) der Halbleiterscheibe treffende Strahlung größer ist als die Intensität (I_{M}) der auf den mittleren Bereich (6) der Halbleiterscheibe (1) treffenden Strahlung und
d) um Ausgleich der im Randbereich (5) der Halbleiterscheibe (1) erhöht auftretenden Wärmeabstrahlung die Intensität (I_{R}+I_{Z}) der auf dem Randbereich (5) der Halbleiterscheibe (1) treffenden Strahlung durch Verändern des Abstandes der Halbleiterscheibe (1) vom Reflektor (101, 111) erhöht wird.

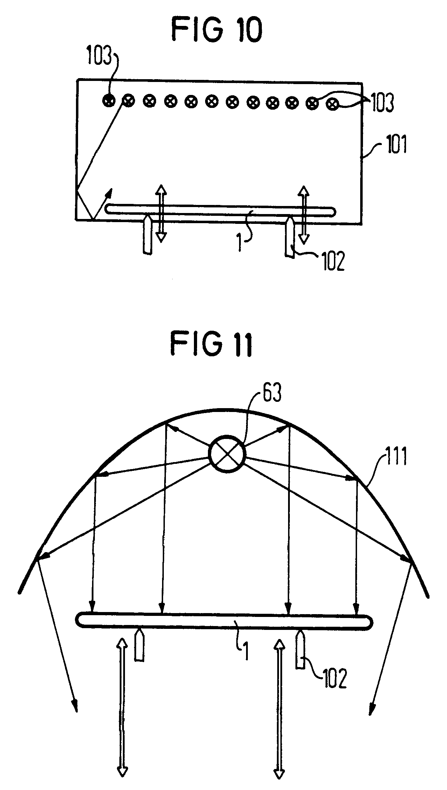

Weitere Ausgestaltungen und Weiterbildungen der Erfindung gehen aus den Unteransprüchen sowie der anhand von Ausführungsbeispielen mit den FIG 10 bis 11 gegebenen Beschreibung hervor.

Es zeigen in schematischer Darstellung:
FIG 5 den zeitlichen Verlauf der Strahlungsintensitäten und Temperaturen im Bereich der Halbleiterscheibenmitte und des Halbleiterscheibenrandes bei einem erfindungsgemäßen Verfahren und
FIG 6 bis 9 Anordnungen Sowie FIG 10 und FIG 11 Anordnungen zur Durchführung des erfindungsgemäßen Verfahrens, wobei die FIG 6, 7, 9, 10, 11 als Schnittdarstellungen mit einer Schnittebene senkrecht zur Oberfläche der Halbleiterscheibe ausgeführt sind und FIG 8 eine Anordnung in Draufsicht zeigt.

### FIG 5

Zur Veranschaulichung eines erfindungsgemäßen Verfahrens zum Kurzzeittempern einer Halbleiterscheibe wird ein Temperprozeß mit einer kurzen Aufheizzeit t₁, einer Temperzeit t₂, während der die Halbleiterscheibe eine konstante Temperatur aufweisen soll, und einer Abkühlzeit t₃ betrachtet.

Die Oberseite der Halbleiterscheibe wird durch eine Hauptbestrahlungsanordnung ganzflächig bestrahlt. Die Intensität I_{M} im Bereich der Halbleiterscheibenmitte ist dabei gleich der Intensität I_{R} im Bereich des Halbleiterscheibenrandes.

Zum Ausgleich der im Bereich des Halbleiterscheibenrandes erhöht auftretende Wärmeabstrahlung wird auf den Randbereich der Halbleiterscheibe zusätzlich eine elektromagnetische Strahlung gerichtet, deren Intensität I_{Z} zeitlich so verändert wird, daß während des gesamten Temperprozesses die Temperatur T_{R} im Bereich des Halbleiterscheibenrandes gleich der Temperatur T_{M} im Bereich der Halbleiterscheibenmitte ist. Der Verlauf der Intensität I_{Z} der zusätzlichen Bestrahlung ist dabei vom Verlauf der Intensitäten I_{M}, I_{R} der Hauptbestrahlungsanordnung abhängig. Wenn sich nach der Aufheizzeit t₁ ein Gleichgewicht zwischen der durch die Halbleiterscheibe absorbierten Energie und der von der Halbleiterscheibe abgestrahlten Energie eingestellt hat, können die Strahlungsintensitäten I_{M}, I_{R} und I_{Z} konstant gehalten werden, um eine gleiche konstante Solltemperatur T_{S} im Bereich der Halbleiterscheibenmitte und im Bereich das Halbleiterscheibenrandes zu erhalten.

Bei langsamer Aufheizgeschwindigkeit muß die zusätzliche Bestrahlung I_{Z} schon bei einer niedrigeren Temperatur einsetzen als bei großer Aufheizgeschwindigkeit, da wegen der längeren Aufheizdauer sich die durch die Wärmeabstrahlung am Halbleiterscheibenrand verursachte Temperatur-Inhomogenität bereits bei niedrigeren Temperaturen ausbildet.

Damit nach dem Abschalten der Hauptbestrahlung (I_{M} = I_{R} = 0) während der Abkühlzeit t₃ die Abkühlraten im Bereich der Halbleiterscheibenmitte und im Bereich des Halbleiterscheibenrandes gleich sind, wird die zusätzliche Bestrahlung I_{Z} nach der Temperzeit t₂ langsam auf Null gesteuert.

Ein Vergleich der Strahlungsintensität I_{M} der Bestrahlung im Bereich der Halbleiterscheibenmitte und der gesamten Strahlungsintensität I_{R} + I_{Z} im Bereich des Halbleiterscheibenrandes zeigt, daß bei dem erfindungsgemäßen Verfahren die relative Intensitätsverteilung der elektromagnetischen Bestrahlung über die Halbleiterscheibe zeitlich variiert wird.

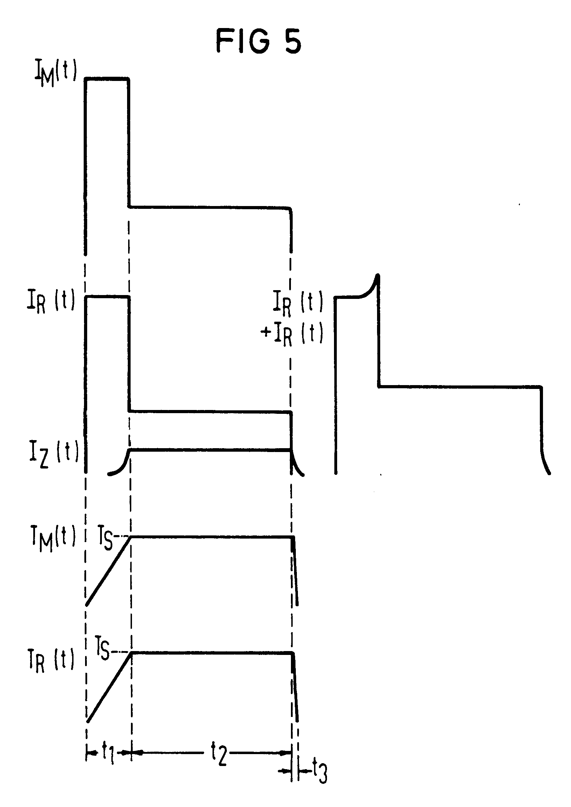

Die in der FIG 5 dargestellten Kurven gelten für einen typischen Temperzyklus mit einer Aufheizrate von 300° C pro Sekunde auf 1100° C, einer Temperzeit von 5 Sekunden bei 1100° C und einer Abkühlphase durch natürliche Wärmeabstrahlung.

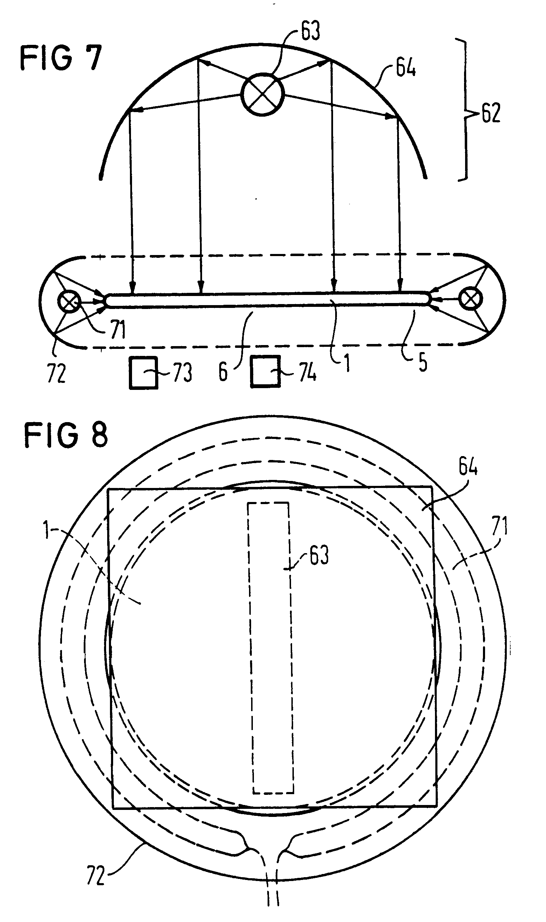

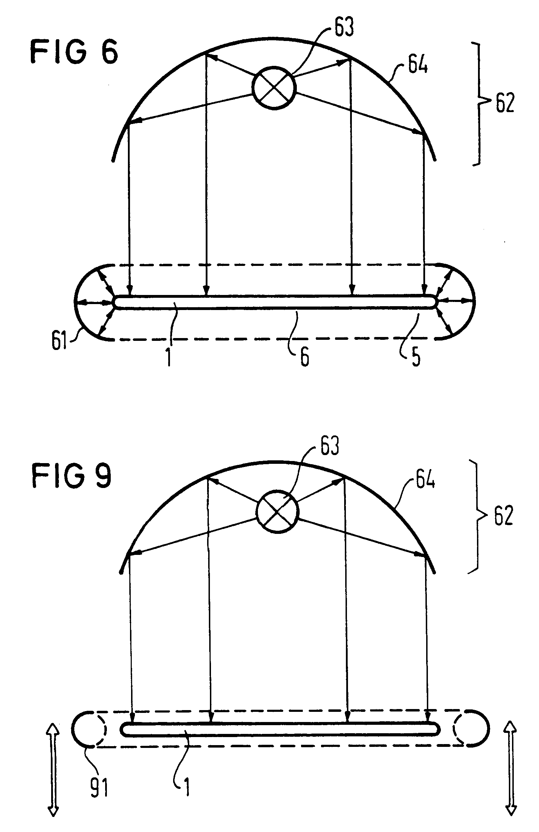

Die ausführungsbeispiele gemäß FIG 6 bis 9 dienen nur zur Erläuterung weil sie nicht Gegenstand der Erfindung sind.

### FIG 6

Zum Ausgleich der im Randbereich 5 der Halbleiterscheibe 1 erhöht auftretenden Wärmeabstrahlung kann ein Reflexionsschirm 61, dessen Seitenwände im Querschnitt halbkreisförmig gewölbt sind, so um den Rand der Halbleiterscheibe 1 angeordnet werden, daß die Wärmeabstrahlung vom Halbleiterscheibenrand 5 wieder auf diese zurückreflektiert wird. Die Wärmeabstrahlung am Halbleiterscheibenrand 5 wird damit zu jeder Zeit selbstregelnd kompensiert. Der Reflexionsschirm 61 aus gut reflektierendem Material kann z.B. aus Metall hergestellt sein.

Als Hauptbestrahlungsanordnung 62 kann eine Bogenentladungslampe 63 dienen, über der ein gewölbter Reflektor 64 angeordnet ist, der so dimensioniert ist, daß die Oberseite der Halbleiterscheibe 1 ganzflächig mit gleicher Intensität bestrahlt wird.

Die eingezeichneten Pfeile deuten den Strahlungsgang schematisch an.

### FIG 7

Die Anordnung weist neben der anhand von FIG 6 beschriebenen Hauptbestrahlungsanordnung 62 eine um den Rand 5 der Halbleiterscheibe 1 angeordnete ringförmige Lichtquelle 71 mit einem die ringförmige Lichtquelle 71 umgebenden Reflektor 72 mit parabolischem Querschnitt auf. Die Regelung der Intensitäten I_{M} und I_{R} der Hauptbestrahlungsanordnung 62 und die Steuerung der Intensität I_{Z} der ringförmigen Lichtquelle 71 erfolgt mittels Temperaturmessungen im Bereich der Halbleiterscheibenmitte und im Bereich des Halbleiterscheibenrandes. Die Intensität I_{Z} der Bestrahlung der Lichtquelle 71 wird aufgrund der ermittelten Temperaturdifferenzen in der Halbleiterscheibenmitte 6 und am Halbleiterscheibenrand 5 geregelt. Die Temperaturmessungen können z.B. mittels Pyrometer 73, 74 erfolgen, die sich für die in Frage kommenden Temperaturbereiche eignen und aufgrund des berührungslosen Meßprinzips die empfindliche Halbleiterscheibe 1 schonen.

### FIG 8

In einer Draufsicht ist die Anordnung auf FIG 7 nochmals dargestellt. Die ringförmige Lichtquelle 71, z.B. eine Wolframlampe, und der Reflektor mit parabolischem Querschnitt 72 sind konzentrisch um den Rand 5 der Halbleiterscheibe 1 angeordnet.

### FIG 9

Als eine weitere Ausgestaltung kann zum Ausgleich der im Randbereich 5 der Halbleiterscheibe 1 erhöht auftretende Wärmeabstrahlung ein ringförmiger Heizstrahler 91 um den Rand der Halbleiterscheibe 1 angeordnet werden, der z.B. Siliziumkarbid enthalten kann, das eine siliziumähnliche Emissivität aufweist. Die Regelung der Intensität I_{Z} der zusätzlichen Bestrahlung erfolgt, wie anhand von FIG 7 beschrieben, mittels Pyrometermessungen im Bereich der Halbleiterscheibenmitte 6 und im Bereich des Halbleiterscheibenrandes 5.

Als weitere Möglichkeit der zeitabhängigen Einstellung der Intensität I_{Z} der zusätzlichen Bestrahlung ist vorgesehen, den Abstand des ringförmigen Heizstrahlers 91 zur Halbleiterscheibe 1 durch Bewegen des Heizstrahler 91 senkrecht zur Halbleiterscheibenoberfläche, zu verändern (durch die Doppelpfeile angedeutet).

Die Hauptbestrahlungsanordnung 62 gleicht der anhand von FIG 6 beschriebenen.

### FIG 10, FIG 11

In einer Ausgestaltung des erfindungsgemäßen Verfahrens ist vorgesehen, als Hauptbestrahlungsanordnung 62 eine Bestrahlungsquelle 103, 63 mit einem Reflektor 101, 111 über der Halbleiterscheibe 1 anzuordnen, die so gestaltet ist, daß bei einem bestimmten Abstand der Halbleiterscheibe 1 vom Reflektor 101, 111 die Oberseite der Halbleiterscheibe ganzflächig mit gleicher Intensität I_{M}, I_{R} bestrahlt wird. Die Halbleiterscheibe 1 ist dabei beweglich, z.B. durch Quarzpins 102, gehalten. Der Reflektor 101, 111 ist so gestaltet, daß beim Verändern des Abstandes der Halbleiterscheibe 1 von der Bestrahlungsquelle 103, 63 in eine bestimmte Richtung die auf den Randbereich der Halbleiterscheibe 1 treffende Strahlung eine größere Intensität aufweist als die auf dem mittleren Bereich der Halbleiterscheibe treffende Strahlung. Durch die Bewegung der Halbleiterscheibe 1 (durch die Doppelpfeile angedeutet) kann daher die im Randbereich der Halbleiterscheibe 1 erhöht auftretende Wärmeabstrahlung ausgeglichen werden. Die Bewegung der Halbleiterscheibe 1 wird dabei mittels Pyrometermessungen, wie anhand von FIG 7 beschrieben, gesteuert.

Als Reflektor kann eine Reflexionskammer 101 verwendet werden, die die Halbleiterscheibe 1 und die aus mehreren Lichtquellen 103, z.B. Wolframlampen, bestehende Bestrahlungsquelle ganz einschließt.

Als Hauptbestrahlungsanordnung kann außerdem eine einzelne Bestrahlungsgelle 63 mit einem die Bestrahlungsquelle 63 und die Halbleiterscheibe 1 überspannenden, gewölbten Reflektor 111 verwendet werden, dessen Abmessungen so gestaltet sind, daß eine entsprechende abstandsabhängige Intensitätsverteilung der Bestrahlung erreicht wird.

Die Erfindung beinhaltet auch Verfahren, bei denen die Unterseite oder Oberseite und Unterseite der Halbleiterscheibe durch eine Hauptbestrahlungsanordnung bestrahlt werden.

Die Steuerung der Intensität I_{Z} der zusätzlichen Bestrahlung kann auch anhand von vorausberechneten Kurven der erforderlichen Intensitätswerte erfolgen.

Das erfindungsgemäße Verfahren kann bei allen Temperaturen angewendet und auch bei mehrstufigen Temperzyklen eingesetzt werden.

## Patentansprüche

1. Verfahren zum Kurzzeittempern einer Halbleiterscheibe durch elektromagnetische Bestrahlung mit einer Hauptbestrahlungsanordnung, die mindestens eine Bestrahlungsquelle aufweist und den größten Teil der zur Erwärmung der Halbleiterscheibe benötigten Energie überträgt, bei dem
a) eine Hauptbestahlungsanordnung (62) verwendet wird, die so beschaffen ist, daß die Halbleiterscheibe (1) mindestens einseitig so bestrahlt wird, daß die Intensitäten (I_{M}, I_{R}) der auf dem mittleren Bereich (6) der Halbleiterscheibe (1) und den Randbereich der Halbleiterscheibe (1) gerichteten Strahlung gleich sind und
b) bei dem zum Ausgleich der im Randbereich (5) der Halbleiterscheibe (1) erhöht auftretenden Wärmeabstrahlung zusätzlich eine die Halbleiterscheibe (1) aufheizende elektromagnetische Strahlung auf den Randbereich (5) gerichtet wird, deren Intensität (I_{Z}) zeitlich so verändert wird, daß während des gesamten Temperprozesses die Temperaturen (T_{M}, T_{R}) im mittleren (6) und im Randbereich (5) der Halbleiterscheibe (1) gleich sind,
**dadurch gekennzeichnet**, daß
c) als Hauptbestrahlungsanordnung eine Bestrahlungsquelle (103, 63) mit einem Reflektor (101, 111) über der Halbleiterscheibe (1) angeordnet wird, die so gestaltet ist, daß bei einem bestimmten Abstand der Halbleiterscheibe (1) vom Reflektor (101, 111) die Halbleiterscheibe (1) so bestrahlt wird, daß die Intensitäten (I_{M}, I_{R}) der auf dem mittleren Bereich (6) und auf den Randbereich (5) treffenden Strahlung gleich sind und daß bei einem anderen Abstand der Halbleiterscheibe (1) vom Reflektor (101, 111) die Intensität (I_{R}+I_{Z}) der auf den Randbereich (5) der Halbleiterscheibe treffende Strahlung größer ist als die Intensität (I_{M}) der auf den mittleren Bereich (6) der Halbleiterscheibe (1) treffenden Strahlung und
d) zum Ausgleich der im Randbereich (5) der Halbleiterscheibe (1) erhöht auftretenden Wärmeabstrahlung die Intensität (I_{R}+I_{Z}) der auf dem Randbereich (5) der Halbleiterscheibe (1) treffenden Strahlung durch Verändern des Abstandes der Halbleiterscheibe (1) vom Reflektor (101, 111) erhöht wird.

2. Verfahren nach Anspruch 1, **dadurch gekennzeichnet**, daß eine Hauptbestrahlungsanordnung (62) verwendet wird, die aus mehreren parallel zur Oberfläche der Halbleiterscheibe (1) nebeneinander angeordneten Lichtquellen (103) besteht und als Reflektor eine Reflektionskammer (101) verwendet wird, die die Halbleiterscheibe (1) und die Lichtquellen (103) ganz einschließt.

3. Verfahren nach Anspruch 1, **dadurch gekennzeichnet**, daß als Hauptbestrahlungsanordnung eine einzelne Bestrahlungsquelle (63) und ein die Halbleiterscheibe (1) und die Bestrahlungsquelle (63) überspannender gewölbter Reflektor (111) verwendet wird, wobei die Abmessungen des Reflektors (111) so gestaltet werden, daß eine entsprechende abstandsabhängige Intensitätsverteilung der Bestrahlung erreicht wird.

4. Verfahren nach einem der Ansprüche 1 bis 3, **dadurch gekennzeichnet**, daß die zeitliche Veränderung der Intensität (I_{Z}) der zusätzlichen auf den Randbereich (5) der Halbleiterscheibe (1) gerichteten Strahlung mittels von am Halbleiterscheibenrand (5) und in der Halbleiterscheibenmitte (6) durchgeführten Temperaturmessungen gesteuert wird.

5. Verfahren nach einem der Ansprüche 1 bis 3, **dadurch gekennzeichnet**, daß die zeitliche Veränderung der Intensität (I_{Z}) der zusätzlichen auf den Randbereich (5) der Halbleiterscheibe (1) gerichteten Strahlung anhand vorausberechneter Kurven der erforderlichen Intensitätswerte gesteuert wird.

6. Verfahren nach 4, **dadurch gekennzeichnet**, daß die Temperaturmessungen mittels Pyrometer (73, 74) durchgeführt werden.

## Claims

1. Method for accelerated annealing of a semiconductor wafer by electromagnetic irradiation using a main irradiation system which comprises at least one irradiation source and transmits most of the energy needed to heat the semiconductor wafer,
a) in which a main irradiation system (62) is used which is so designed that the semiconductor wafer (1) is irradiated on at least one side and that the intensities (I_{M}, I_{R}) of the radiation directed at the central region (6) of the semiconductor wafer (1) and the peripheral region of the semiconductor wafer (1) are equal, and
b) in which, to compensate for the heat radiation occurring at an increased level in the peripheral region (5) of the semiconductor wafer (1), an electromagnetic radiation which heats the semiconductor wafer (1) is additionally directed at the peripheral region (5), the intensity (I_{Z}) of said radiation being varied with time in such a way that, throughout the entire annealing process, the temperatures (T_{M}, T_{R}) in the central region (6) and in the peripheral region (5) of the semiconductor wafer (1) are equal,
characterized in that
c) there is disposed above the semiconductor wafer (1) as main irradiation system an irradiation source (103, 63) having a reflector (101, 111), which irradiation source is so designed that, with a certain distance of the semiconductor wafer (1) from the reflector (101, 111), the semiconductor wafer (1) is irradiated in such a way that the intensities (I_{M}, I_{R}) of the radiation incident on the central region (6) and on the peripheral region (5) are equal and that, with another distance of the semiconductor wafer (1) from the reflector (101, 111), the intensity (I_{R} + I_{Z}) of the radiation incident on the peripheral region (5) of the semiconductor wafer is greater than the intensity (I_{M}) of the radiation incident on the central region (6) of the semiconductor wafer (1), and
d) to compensate for the heat radiation encountered at an increased level in the peripheral region (5) of the semiconductor wafer (1), the intensity (I_{R} + I_{Z}) of the radiation incident on the peripheral region (5) of the semiconductor wafer (1) is increased by varying the distance of the semiconductor wafer (1) from the reflector (101, 111).

2. Method according to Claim 1, characterized in that a main irradiation system (62) is used which comprises a plurality of light sources (103) disposed alongside one another parallel to the surface of the semiconductor wafer (1) and a reflection chamber (101) which completely encloses the semiconductor wafer (1) and the light sources (103) is used as reflector.

3. Method according to Claim 1, characterized in that a single irradiation source (63) and an arched reflector (111) which spans the semiconductor wafer (1) and the irradiation source (63) are used as main irradiation system, the dimensions of the reflector (111) being so designed that a suitable, distance-dependent intensity distribution of the irradiation is achieved.

4. Method according to one of Claims 1 to 3, characterized in that the variation with time of the intensity (I_{Z}) of the additional radiation directed at the peripheral region (5) of the semiconductor wafer (1) is controlled by means of temperature measurements carried out at the semiconductor wafer periphery (5) and in the semiconductor wafer centre (6).

5. Method according to one of Claims 1 to 3, characterized in that the variation with time of the intensity (I_{Z}) of the additional radiation directed at the peripheral region (5) of the semiconductor wafer (1) is controlled on the basis of precalculated curves of the required intensity values.

6. Method according to Claim 4, characterized in that the temperature measurements are carried out by means of a pyrometer (73, 74).

## Revendications

1. Procédé de recuit de brève durée d'une pastille semiconductrice par application d'un rayonnement électromagnétique à l'aide d'un dispositif d'irradiation principal, qui possède au moins une source de rayonnement et transmet la majeure partie de l'énergie nécessaire pour l'échauffement de la pastille semiconductrice, selon lequel
a) on utilise un dispositif d'irradiation principal (62) qui est agencé de telle sorte que la pastille semiconductrice (1) est irradiée au moins sur une face pour que les intensités (I_{M}, I_{R}) du rayonnement, qui est dirigé vers la zone centrale (6) de la pastille semiconductrice (1) et sur la zone marginale de la pastille semiconductrice (1), soient égales, et
b) pour la compensation du dégagement thermique par rayonnement, qui apparaît d'une manière accrue dans la zone marginale (5) de la pastille semiconductrice (1), un rayonnement électromagnétique, qui chauffe la pastille semiconductrice (1), est dirigé en supplément sur la zone marginale (5), l'intensité (I_{Z}) de ce rayonnement étant modifiée dans le temps de telle sorte que pendant l'ensemble du processus de recuit, les températures (T_{M}, T_{R}) dans la zone médiane (6) et dans la zone marginale (5) de la pastille semiconductrice (1) sont égales,
caractérisé par le fait que
c) comme dispositif d'irradiation principal, une source d'irradiation (103,63) comportant un réflecteur (101,111) est disposée au-dessus de la pastille semiconductrice (1) et qui est agencée de telle sorte que, dans le cas d'un écart déterminé entre la pastille semiconductrice (1) et le réflecteur (101, 111), la pastille semiconductrice (1) est irradiée de telle sorte que les intensités (I_{M}, I_{R}) du rayonnement, qui rencontre la partie médiane (6) et la zone marginale (5), sont égales et que, pour une autre distance entre la pastille semiconductrice (1) et le réflecteur (101,111), l'intensité (I_{R}+I_{Z}) du rayonnement qui rencontre la zone marginale (5) de la pastille semiconductrice, est supérieure à l'intensité (I_{M}) du rayonnement qui rencontre la zone centrale (6) de la pastille semiconductrice (1), et
d) pour la compensation de l'évacuation thermique par rayonnement, qui se produit d'une manière accrue dans la zone marginale (5) de la pastille semiconductrice (1), on augmente l'intensité (I_{R}+I_{Z}) du rayonnement, qui rencontre la zone marginale (5) de la pastille semiconductrice (1), en modifiant la distance entre la pastille semiconductrice (1) et le réflecteur (101,111).

2. Procédé suivant la revendication 1, caractérisé par le fait qu'on utilise un dispositif d'irradiation principal (62), qui est constitué par plusieurs sources de lumière (103) disposées côte-à-côte parallèlement à la surface de la pastille semiconductrice (1), et qu'on utilise comme réflecteur une chambre de réflexion (101), qui enveloppe complètement la pastille semiconductrice (1) et les sources de lumière (103).

3. Procédé suivant la revendication 1, caractérisé par le fait qu'on utilise comme dispositif d'irradiation principal une source individuelle d'irradiation (63) et un réflecteur cintré (111), qui s'étend de manière à englober la pastille semiconductrice (1) et la source d'irradiation (63), les dimensions du réflecteur (111) étant choisies pour l'obtention d'une distribution correspondante de l'intensité de l'irradiation, qui dépend de la distance.

4. Procédé suivant l'une des revendications 1 à 3, caractérisé par le fait que la variation de l'intensité dans le temps (I_{Z}) du rayonnement supplémentaire dirigé sur la zone marginale (5) du disque semiconducteur (1), est commandée au moyen de mesures de température, qui sont exécutées au niveau du bord (5) de la pastille semiconductrice et au centre (6) de la pastille semiconductrice.

5. Procédé suivant l'une des revendications 1 à 3, caractérisé par le fait que la variation résiduelle de l'intensité (I_{Z}) du rayonnement supplémentaire dirigé sur la zone marginale (5) de la pastille semiconductrice (1) est commandée sur la base de courbes préalablement calculées des valeurs des intensités.

6. Procédé suivant la revendication 4, caractérisé par le fait que les mesures de température sont exécutées à l'aide de pyromètres (73,74).
